# EUROPEAN PATENT APPLICATION

(11) **EP 4 629 778 A1**
(43) Date of publication of application: **08.10.2025**
(21) Application number: 25163921.7
(22) Date of filing: 14.03.2025
(51) Int. Cl.: H10D 89/60, H10D 8/01, H10D 12/01, H01L 25/065, H02H 9/04

(54) **UNIDIRECTIONAL TRANSIENT VOLTAGE SUPPRESSOR DEVICE WITH LOW CLAMPING VOLTAGE**

(30) Priority: 29.03.2024 CN 202410385090
(71) Applicant: Littelfuse Semiconductor (Wuxi) Co., Ltd., Wuxi, Jiangsu 214142 (CN)
(72) Inventor: Zhou, Jifeng, Wuxi, 214142 (CN); Zhang, Glenda, Wuxi, 214142 (CN)
(74) Representative: Arnold & Siedsma

(57) **Abstract**

A transient voltage suppression device, apparatus, structure and associated methods thereof. The device includes a first voltage suppression device having a substrate, a first base layer, and a second base layer. The substrate is coupled to the first base layer, and to the second base layer. The device includes a second voltage suppression device having a substrate, a first base layer, a second base layer, and a third base layer. The second voltage suppression device substrate is coupled to the second voltage suppression device first, second and third base layers. The second voltage suppression device first base layer includes one or more first regions. The second voltage suppression device includes a doping region disposed across at least portions of the second voltage suppression device first base layer and the second voltage suppression device substrate. The first voltage suppression device is coupled to the second voltage suppression device.

## Description

### TECHNICAL FIELD

This disclosure relates generally to the field of power semiconductor discrete devices, and in particular, to transient voltage suppressor devices having low clamping voltage.

### BACKGROUND

A discrete semiconductor is a device specified to perform an elementary electronic function and is not divisible into separate components functional in themselves. Power semiconductors are used as switches or rectifiers in power electronics. Diodes, transistors, thyristors, and rectifiers are examples of discrete power semiconductors. Discrete power semiconductors are found in a variety of different environments, from very low power systems up to very high-power systems.

Transient voltage suppression (TVS) diodes are electronic components designed to protect sensitive electronics from high voltage transients. TVS diodes can respond to overvoltage events faster than most other types of circuit protection devices and are available in a variety of surface mount and through-hole circuit board mounting formats. TVS diodes are generally used to protect against electrical overstress such as those induced by lightning strikes, inductive load switching, and electrostatic discharge (ESD) associated with transmission on data lines and electronic circuits. However, existing TVS devices are not able to provide sufficient low clamping voltage during operation.

### SUMMARY

The following summary is provided to introduce a selection of concepts in a simplified form that are further described below in the detailed description. This summary is not intended to identify key or essential features of the claimed subject matter, nor is it intended as an aid in determining the scope of the claimed subject matter.

The current subject matter relates to a transient voltage suppression device. The device may include a first voltage suppression device that may have a first voltage suppression device substrate, a first voltage suppression device first base layer, and a first voltage suppression device second base layer. The first voltage suppression device substrate may be coupled to the first voltage suppression device first base layer, and to the first voltage suppression device second base layer. The transient voltage suppression device may also include a second voltage suppression device that may have a second voltage suppression device substrate, a second voltage suppression device first base layer, a second voltage suppression device second base layer, and a second voltage suppression device third base layer. The second voltage suppression device substrate may be coupled to the second voltage suppression device first base layer and may be coupled to the second voltage suppression device second and third base layers. The second voltage suppression device first base layer may include one or more first regions. The second voltage suppression device may include a doping region disposed across at least portions of the second voltage suppression device first base layer and the second voltage suppression device substrate. The first voltage suppression device may be coupled to the second voltage suppression device.

The current subject matter may include one or more of the following optional features. The first voltage suppression device substrate may be a N type substrate and the second voltage suppression device substrate may be a N- type substrate. The first voltage suppression device first base layer and the second voltage suppression device first base layer may be p-base layers. The first voltage suppression device second base layer and the second voltage suppression device second base layer may be N+-base layers. The second voltage suppression device third base layer may be p-base type layer. One or more first regions may be N+-type regions. The doping region may be N+-type region. Formations of at least one of: the one or more first regions in the second voltage suppression device first base layer and the doping region, and any combination thereof may form one or more NPN configurations of the transient voltage suppression device.

At least one of: one or more first regions in the second voltage suppression device first base layer and the doping region may be doped using one or more dopants. One or more dopants may include at least one of the following: phosphorous, boron, arsenic, gallium, and any combination thereof. At least one of the one or more first regions and the doping region may have a predetermined concentration of the one or more dopants. Each of one or more first regions and the doping region may have a predetermined depth. The transient voltage suppression device may be characterized by a clamping voltage, where the clamping voltage of the transient voltage suppression device may be determined as a function of at least one of: a predetermined concentration of the one or more dopants, a predetermined depth of the one or more first regions, a predetermined depth of the doping region, and any combinations thereof. Each of one or more first regions and the doping region may have the same concentration of one or more dopants. Alternatively, or in addition, each of the one or more first regions and the doping region may have a different concentration of the one or more dopants.

The first voltage suppression device may be a unidirectional transient voltage suppression device.

The second voltage suppression device may be a unidirectional transient voltage suppression device.

The transient voltage suppression device may be a unidirectional transient voltage suppression device.

The first voltage suppression device first base layer may be coupled to an anode termination layer, and the second voltage suppression device second and third base layers may be coupled to a cathode termination layer.

The second voltage suppression device may be a SIDACTor device.

The current subject matter relates to a method of manufacturing of a transient voltage suppression device. The method may include providing a first voltage suppression device that may have a first voltage suppression device substrate, a first voltage suppression device first base layer, and a first voltage suppression device second base layer, the first voltage suppression device substrate may be coupled to the first voltage suppression device first base layer, and may be coupled to the first voltage suppression device second base layer; providing a second voltage suppression device that may have a second voltage suppression device substrate, a second voltage suppression device first base layer, a second voltage suppression device second base layer, and a second voltage suppression device third base layer, the second voltage suppression device substrate may be coupled to the second voltage suppression device first base layer and may be coupled to the second voltage suppression device second and third base layers, wherein the second voltage suppression device first base layer may include one or more first regions, the second voltage suppression device may include a doping region disposed across at least portions of the second voltage suppression device first base layer and the second voltage suppression device substrate; and coupling the first voltage suppression device and the second voltage suppression device.

The details of one or more variations of the subject matter described herein are set forth in the accompanying drawings and the description below. Other features and advantages of the subject matter described herein will be apparent from the description and drawings, and from the claims.

### BRIEF DESCRIPTION OF THE DRAWINGS

The accompanying drawings, which are incorporated in and constitute a part of this specification, show certain aspects of the subject matter disclosed herein and, together with the description, help explain some of the principles associated with the present disclosure. In the drawings,
FIG. 1 illustrates an example of a transient voltage suppressor (TVS) device;
FIG. 2 illustrates an unidirectional TVS device, according to the present disclosure;
FIGS. 3a-b illustrate example current-voltage plots; and
FIG. 4 illustrates an exemplary process, according to the present disclosure.

The drawings are not necessarily to scale. The drawings are merely representations, not intended to portray specific parameters of the disclosure. The drawings are intended to depict the present disclosure and therefore, are not to be considered as limiting in scope. In the drawings, like numbering represents like elements.

Further, certain elements in some of the figures may be omitted, and/or illustrated not-to-scale, for illustrative clarity. Cross-sectional views may be in the form of "slices", and/or "near-sighted" cross-sectional views, omitting certain background lines otherwise visible in a "true" cross-sectional view, for illustrative clarity. Additionally, for clarity, some reference numbers may be omitted in certain drawings.

### DETAILED DESCRIPTION

Various approaches in accordance with the present disclosure will now be described more fully hereinafter with reference to the accompanying drawings.

To address these and potentially other deficiencies of currently available solutions, the present disclosure relates to methods, systems, articles of manufacture, and the like that can, among other possible advantages, provide a transient voltage suppressor (TVS) device having a low clamping voltage characteristic.

Voltage transients are defined as short duration surges of electrical energy and are the result of the sudden release of energy previously stored and/or induced by other means, such as, for example, heavy inductive loads, lightning, etc. Voltage transients may be classified into predictable or repeatable transients and random transients. In electrical or electronic circuits, this energy can be released in a predictable manner via controlled switching actions, or randomly induced into a circuit from external sources. Repeatable transients are frequently caused by the operation of motors, generators, and/or the switching of reactive circuit components. On the other hand, random transients are often caused by electrostatic discharge (ESD) and lightning, which generally occur unpredictably.

ESD is characterized by very fast rise times and very high peak voltages and currents, which may be the result of an imbalance of positive and negative charges between objects. ESD that is generated by everyday activities can surpass a vulnerability threshold of standard semiconductor technologies. In case of lightning, even though a direct strike is destructive, voltage transients induced by lightning are not the result of a direct strike. When a lightning strike occurs, the event can generate a magnetic field, which, in turn, can induce voltage transients of large magnitude in nearby electrical cables. For example, a cloud-to-cloud strike will affect not only overhead cables, but also buried cables. Even a strike 1 mile distant (1.6km) can generate 70 volts in electrical cables. In a cloud-to-ground strike, the voltage transient generating effect is significantly greater.

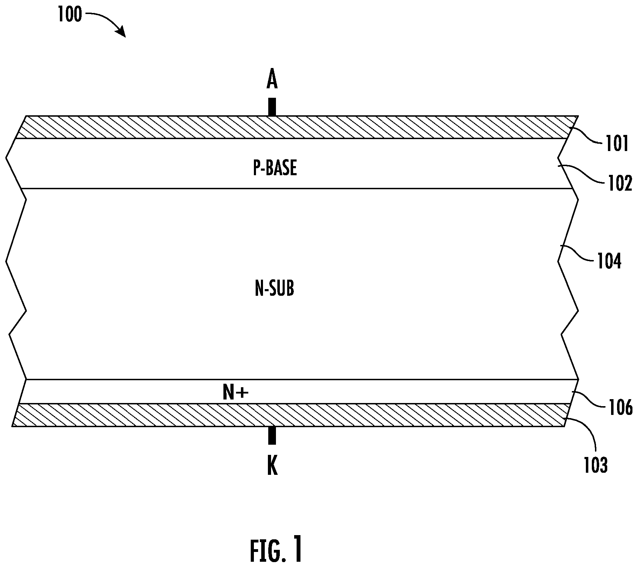

FIG. 1 illustrates a transient voltage suppressor (TVS) device 100. The TVS device 100 can be formed in a monolithic semiconductor substrate, such as silicon. In particular, the TVS device 100 can include a substrate 104, a first base layer 102, and a second base layer 106. The substrate 104 can be formed having a polarity of a first type. The substrate 104 can be formed between the first base layer 102 and the second base layer 106. The first and second base layers 102, 106 can be formed having polarities of a second type and a third type, respectively. The second type polarity may be opposite to the first type polarity. As shown in FIG. 1, the substrate 104 can be an N-type substrate. The first base layer 102 can be a P-type base layer. The second base layer 106 can be N+-base layer. Further, the first base layer 102 can form a P-N junction 105 with the substrate 104. The second base layer 106 can form N+N junction 107 with the substrate 104.

As can be understood, while FIG. 1 illustrates the device 100 being based upon a N-type substrate, the TVS device 100 can have a P-type substrate with N-type first and second base layers disposed on opposite surfaces. The TVS device 100 may be a unidirectional device, however, as can be understood, the TVS 100 may be any other type of device.

Further, the TVS device 100 can also include terminals 101 and 103 for connection of the TVS device 100 to various circuit components (e.g., printed circuit board, etc.). The first terminal 101 may be referred to as an anode ("A") terminal. The anode terminal 101 may be formed above the first base layer 101. The second terminal 103 may be referred to as a cathode ("K") terminal. The cathode terminal 103 may be formed below the second base layer 106. As can be understood, the designations of "above" and "below" are meant for illustrative purposes only and are intended to limit the current subject matter. The first and second terminals 101, 103 may be manufactured from a conductive material, such as, for example, but not limited to, copper, copper alloy, silver, metallic alloys, etc., and/or any combinations thereof.

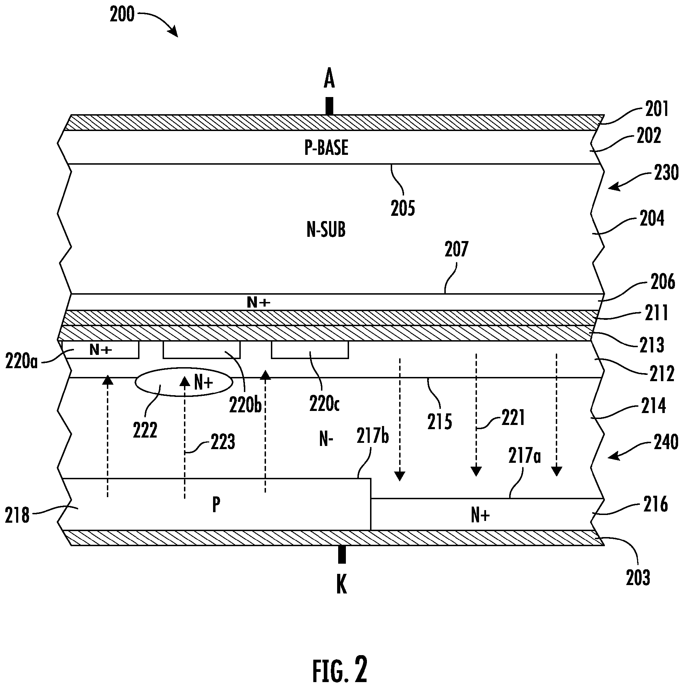

FIG. 2 illustrates an exemplary unidirectional TVS device 200, according to the present disclosure. Similar to the device 100 shown in FIG. 1, the TVS device 200 may be configured to be formed in a semiconductor substrate, such as, for example, silicon. As can be understood, other substrate materials may be used. However, the device 200 may be configured to provide an advantageous structure, that may be helpful in providing a low clamping voltage while avoiding degrading of the surge performance of the TVS device, which may be useful in various industries, such as, for example, automotive applications.

The TVS 200 may be configured to include a combination of device, such as, for example a TVS device 230 (which may be similar to the TVS device 100 shown in FIG. 1) and a SIDACTor device 240 that may be coupled to the TVS device 230. The SIDACTor device 240 (as for example, available from Littelfuse, Inc., Chicago, Illinois, USA) may be designed to suppress overvoltage transients in various electronic equipment (e.g., telecommunications, data communications, etc. equipment), and may be able to divert currents as high as 5000A to ground within nanoseconds of reaching their breakover voltage. Further, the SIDACTor device 240 may be used for protection against peak current pulses. SIDACTor device 240 may be solid state crowbar device that may be designed to protect equipment located in hostile environments from overvoltage transient currents within nanoseconds.

Similar to the TVS device 100 shown in FIG. 1, the TVS device 230 may include a substrate 204, a first base layer 202, and a second base layer 206. The substrate 204 may have a polarity of a first type, e.g., N-type. The substrate 204 may be formed between the first base layer 202 and the second base layer 206. The first base layer 202 may have a polarity of a second type, e.g., P-type. The second base layer 206 may have a polarity of a third type, e.g., N+-type. The first base layer 202 may form a P-N junction 205 with the substrate 204. The second base layer 206 may form N+N junction 207 with the substrate 204. Similar to the TVS device 100, the device 230, while shown being based upon a N-type substrate, may have a P-type substrate with N-type first and second base layers disposed on opposite surfaces. The TVS device 230 may be a unidirectional device, however, as can be understood, the TVS 230 may be any other type of device.

Further, the TVS device 230 may also include terminal layers 201 and 211. The first terminal layer 211 may be formed above and coupled to the first base layer 202. It may also be coupled to an anode ("A") terminal. The second terminal layer 211 may be formed below the second base layer 206. As can be understood, the designations of "above" and "below" are meant for illustrative purposes only and are intended to limit the current subject matter. The first and second terminal layers 201 and 211 may be manufactured from a conductive material, such as, for example, but not limited to, copper, copper alloy, silver, metallic alloys, etc., and/or any combinations thereof.

The SIDACTor device 240 may include a substrate 214, a first base layer 212, a second base layer 216, and a third base layer 218. The substrate 214 may have a polarity of a first type, e.g., N- type. The substrate 214 may be formed between the first base layer 212 and the second and third base layers 216, 218. The first base layer 212 and the third base layer 218 may have a polarity of a second type, e.g., P-type. The second base layer 216 may have a polarity of a third type, e.g., N+-type. The SIDACTor device 240, while shown being based upon a N-type substrate, may have a P-type substrate with corresponding first, second and third base layers disposed on opposite surfaces. The first base layer 212 may form a P-N junction 215 with the substrate 214. The second base layer 216 may form a P-N junction 217a with the substrate 214 and the third base layer 218 may form a P-N junction 217b with the substrate 214. The SIDACTor device 240 may be a unidirectional device, however, as can be understood, the SIDACTor 240 may be any other type of device.

The first base layer 212 may include one or more regions 220 (a, b, c). The region(s) 220 may be formed using one or more dopants, such as, for example, phosphorous, boron, arsenic, gallium, and/or any other desired materials. Each region 220 may be formed using the same dopant materials and/or different dopant materials.

The combination of the polarities of the region(s) 220, the first base layer 212 and the substrate 214 may create a NPN configuration that may be conducive to creating a lower clamping voltage of the SIDACTor device 240. The doping and/or depth of the region(s) 220may be selected depending on a desired clamping voltage of the device 200. The clamping voltage-may be referred to as a voltage- using which the device 200 may be configured to conduct its fully rated current (e.g., hundreds of amperes, thousands of amperes, etc.). Alternatively, or in addition, the polarities and/or the depth/doping concentration of the regions(s) 220 may be selected based on a desired breakdown voltage of the TVS device 200. The breakdown voltage may be referred to as the largest reverse voltage that may be applied without causing an exponential increase in leakage current in the TVS device 200.

The dopant concentration in the layer(s) 220 may be uniform. Alternatively, or in addition, the concentration may be non-uniform. This may allow for varying the clamping voltage of the TVS device 200. The layer(s) 220 may also have a predetermined thickness. The thickness of the layer(s) 220 may be less than the thickness of the substrate 214. The thickness of the layer(s) 220 may also be less than the thickness of the first base layer 212. As can be understood, any other types of doping of layer(s) 220 (and/or any other components of the TVS device 200) are possible.

An additional doping region 222 may be disposed across at least portions of the first base layer 212 and the substrate 214. The doping region 222 may be configured to have a polarity that may be different than the polarities of the first base region 212 and the substrate 214. The polarity of the doping region 222 may be the same as the polarities of the region(s) 220. For example, the polarity of the doping region 222 may be N+-type. The doping region 222 may be configured to create additional junctions with the substrate 214 and the first base layer 212.

Further, equal portions of the doping region 222 may be distributed across the first base layer 212 and the substrate 214. Alternatively, or in addition, as for example, is shown in FIG. 2, the substrate 214 may include a larger portion of the doping region 222 and the first base layer 212 may include a smaller portion of the doping region 222. The substrate 214 may include a smaller portion of the doping region 222 and the first base layer 212 may include a larger portion of the doping region 222.

The doping region 222 may be configured to define a breakdown voltage of the SIDACTor device 240. The presence of the doping region 222 (along with other components of the SIDACTor device 240) may allow the SIDACTor device 240 to switch from an OFF state to an ON state upon the current exceeding the value of a switching current *Iₛ.* Thus, at a lower current density, SIDACTor device 240 may be configured to "share" a portion of voltage with the TVD device 230, while at a higher current density, the voltage across the SIDACTor device 240 may decrease to a low level (e.g., approximately 1-2 Volts (V)). At the same time, increase in current density increases voltage across the TVS device 230. Thus, a combination of the TVS device 230 and SIDACTor device 240, the TVS device 200 may be configured to have a lower clamping voltage and a higher peak pulse current, while sustaining high enough reverse standoff voltage (*V_{R}*)*.*

As shown in FIG. 2, the second base layer 216 and the third base layer 218 may be positioned adjacent to one another and below the substrate 214. The thickness of the second base layer 216 may be greater than the thickness of the third base layer 218. Alternatively, or in addition, the thicknesses of the base layers 216 and 218 may be equal and/or the thickness of the second base layer 216 may be less than the thickness of the third base layer 218. The second base layer 216 and the third base layer 218 may also be coupled to a terminal layer 203, which may be disposed below the layers 216 and 218. The terminal layer 203 may be coupled to a cathode ("K") terminal. The first and second terminal layers 201, 203 may be manufactured from a conductive material, such as, for example, but not limited to, copper, copper alloy, silver, metallic alloys, etc., and/or any combinations thereof. The cathode and anode terminals to which the terminal layers 201 and 203 may be coupled, respectively, may be used for coupling the device 200 to one or more electronic components (e.g., printed circuit board, etc.).

During a first operational state, the SIDACTor device 240 may be configured to allow current flow in a first direction 221. For example, the current may flow from the first base layer 212 to the second base layer 216. In a second operational state, the SIDACTor device 240 may be configured to allow current flow in a second direction 223. In this direction, the current may flow from the third base layer 218 to the first base layer 212, as well as the doping region 222 and regions 220 (a, b, c).

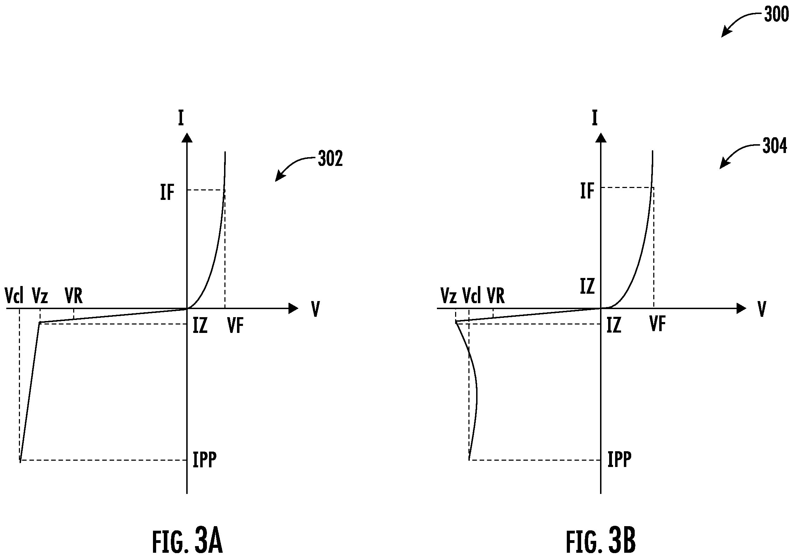

FIGS. 3a-b illustrate example current-voltage plots. FIG. 3a illustrates a plot 302 showing clamping voltage of an existing TVS device. FIG. 3b illustrates a plot 304 showing clamping voltage of the current subject matter's TVS device (e.g., TVS device 200 shown in FIG. 2). As shown in FIG. 3, the current subject matter's TVS device 200 has substantially reduced clamping voltage. In particular, the clamping voltage (*V_{cl}*) of the TVS device 200 may be between the device's reverse breakdown voltage (*V_{z}*) and reverse standoff voltage (*V_{R}*), whereas for an existing device *V_{cl}* is less than voltage *V_{z}*.

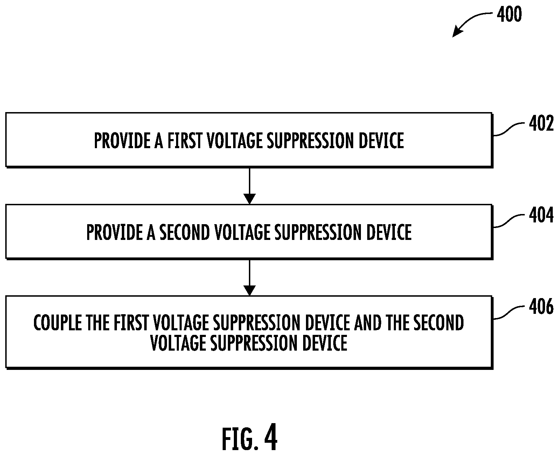

FIG. 4 illustrates a process 400 for manufacturing a transient voltage suppressor device, according to the present disclosure . The process 400 may be used to manufacture, for example, TVS device 200 shown in FIG. 2.

At 402, a first voltage suppression device may be provided, the first device may include a substrate, a first base layer, and a second base layer. For example, the substrate may be the substrate 204; the first base layer may be the first base layer 202; and the second base layer may be the second base layer 206. The substrate may be a n-type substrate. The first base layer may be a p-base layer and the second base layer may be N+-base layer. The substrate may be coupled to the first base layer on one side. The substrate may also be coupled to the second base layer on an opposite side, as for example shown in FIG. 2. The coupling of the substrate and the first base layer may be configured to form a first P-N junction and the coupling of the substrate and the second base layer may be configured to form a second P-N junction. The first voltage suppression device may be a TVS device (e.g., TVS device 230).

At 402, a second voltage suppression device may be provided. The second voltage suppression device may include a substrate (e.g., substrate) 214, a first base layer (e.g., layer 212), a second base layer (e.g., layer 216), and a third base layer (e.g., layer) 218. The substrate may be formed between the first base layer and the second and third base layers. The substrate may be an N- type substrate; the first base layer and the third base layer may be P-type layers. The second base layer may be an N+-type layer. The first base layer may form a P-N junction with the substrate; the second base layer may form a N+N junction with the substrate; and the third base layer may form a P-N junction with the substrate. Further, the first base layer may include one or more regions (e.g., regions 220 (a, b, c), as shown in FIG. 2). The second device may include a doping region (e.g., doping region 222) that may be disposed across at least portions of the first base layer and the substrate and that may have a polarity that may be different than the polarities of the first base region and the substrate. The second voltage suppression device may be a SIDACTor device (e.g., device 240).

At 406, the first voltage suppression device may be coupled to the second voltage suppression device. The first voltage suppression device may also be coupled to an anode terminal of the transient voltage suppression device and the second voltage suppression device may be coupled to a cathode terminal of the transient voltage suppression device.

The components and features of the devices described above may be implemented using any combination of discrete circuitry, application specific integrated circuits (ASICs), logic gates and/or single chip architectures. Further, the features of the devices may be implemented using microcontrollers, programmable logic arrays and/or microprocessors or any combination of the foregoing where suitably appropriate. It is noted that hardware, firmware and/or software elements may be collectively or individually referred to herein as "logic" or "circuit."

It will be appreciated that the exemplary devices shown in the block diagrams described above may represent one functionally descriptive example of the present disclosure. Accordingly, division, omission or inclusion of block functions depicted in the accompanying figures does not infer that the hardware components, circuits, software and/or elements for implementing these functions would necessarily be divided, omitted, or included in embodiments.

For the sake of convenience and clarity, terms such as "top", "bottom", "upper", "lower", "vertical", "horizontal", "lateral", "transverse", "radial", "inner", "outer", "left", and "right" may be used herein to describe the relative placement and orientation of the features and components, each with respect to the geometry and orientation of other features and components appearing in the perspective, exploded perspective, and cross-sectional views provided herein. Said terminology is not intended to be limiting and includes the words specifically mentioned, derivatives therein, and words of similar import.

What has been described above includes examples of the disclosed architecture. It is, of course, not possible to describe every conceivable combination of components and/or methodologies, but one of ordinary skill in the art may recognize that many further combinations and permutations are possible. Accordingly, the novel architecture is intended to embrace all such alterations, modifications and variations that fall within the spirit and scope of the appended claims.

All directional references (e.g., proximal, distal, upper, lower, upward, downward, left, right, lateral, longitudinal, front, back, top, bottom, above, below, vertical, horizontal, radial, axial, clockwise, and counterclockwise) are just used for identification purposes to aid the reader's understanding of the present disclosure, and do not create limitations, particularly as to the position, orientation, or use of this disclosure. Connection references (e.g., attached, coupled, connected, and joined) are to be construed broadly and may include intermediate members between a collection of elements and relative movement between elements unless otherwise indicated. As such, connection references do not necessarily infer that two elements are directly connected and in fixed relation to each other.

Further, identification references (e.g., primary, secondary, first, second, third, fourth, etc.) are not intended to connote importance or priority but are used to distinguish one feature from another. The drawings are for purposes of illustration only and the dimensions, positions, order and relative sizes reflected in the drawings attached hereto may vary.

## Claims

1. A transient voltage suppression device, comprising:
a first voltage suppression device having a first voltage suppression device substrate, a first voltage suppression device first base layer, and a first voltage suppression device second base layer, the first voltage suppression device substrate coupled to the first voltage suppression device first base layer, and coupled to the first voltage suppression device second base layer;
a second voltage suppression device having a second voltage suppression device substrate, a second voltage suppression device first base layer, a second voltage suppression device second base layer, and a second voltage suppression device third base layer, the second voltage suppression device substrate being coupled to the second voltage suppression device first base layer and being coupled to the second voltage suppression device second and third base layers, wherein the second voltage suppression device first base layer includes one or more first regions, the second voltage suppression device includes a doping region disposed across at least portions of the second voltage suppression device first base layer and the second voltage suppression device substrate; and
wherein the first voltage suppression device is coupled to the second voltage suppression device.

2. The transient voltage suppression device according to claim 1, wherein the first voltage suppression device substrate is a N type substrate and the second voltage suppression device substrate is a N- type substrate.

3. The transient voltage suppression device according to claim 1 or 2, wherein
the first voltage suppression device first base layer and the second voltage suppression device first base layer are p-base layers; and
the first voltage suppression device second base layer and the second voltage suppression device second base layer are N+-base layers.

4. The transient voltage suppression device according to any of the claims 1-3, wherein the second voltage suppression device third base layer is p-base type layer.

5. The transient voltage suppression device according to any of the claims 1-4, wherein the one or more first regions are N+-type regions.

6. The transient voltage suppression device according to any of the claims 1-5, wherein the doping region is N+-type region.

7. The transient voltage suppression device according to any of the claims 1-5 wherein formations of at least one of: the one or more first regions in the second voltage suppression device first base layer and the doping region, and any combination thereof form one or more NPN configurations of the transient voltage suppression device.

8. The transient voltage suppression device according to any of the preceding claims, wherein at least one of: the one or more first regions in the second voltage suppression device first base layer and the doping region are doped using one or more dopants.

9. The transient voltage suppression device according to claim 8, with one or more of the following:
- wherein the one or more dopants include at least one of the following: phosphorous, boron, arsenic, gallium, and any combination thereof;
- wherein at least one of the one or more first regions and the doping region have a predetermined concentration of the one or more dopants;
- wherein each of the one or more first regions and the doping region have a predetermined depth.

10. The transient voltage suppression according to claim 8 or 9, wherein the transient voltage suppression device is **characterized by** a clamping voltage, where the clamping voltage of the transient voltage suppression device is determined as a function of at least one of: a predetermined concentration of the one or more dopants, a predetermined depth of the one or more first regions, a predetermined depth of the doping region, and any combinations thereof.

11. The transient voltage suppression according to any of the claims 8-10, wherein each of the one or more first regions and the doping region has the same concentration of the one or more dopants or wherein each of the one or more first regions and the doping region has a different concentration of the one or more dopants.

12. The transient voltage suppression device according to any of the preceding claims with one or more of the following:
- wherein the first voltage suppression device is a unidirectional transient voltage suppression device;
- wherein the second voltage suppression device is a unidirectional transient voltage suppression device;
- wherein the transient voltage suppression device is a unidirectional transient voltage suppression device.

13. The transient voltage suppression device according to any of the preceding claims, wherein the first voltage suppression device first base layer is coupled to an anode termination layer, and the second voltage suppression device second and third base layers are coupled to a cathode termination layer.

14. The transient voltage suppression device according to any of the preceding claims, wherein the second voltage suppression device is a SIDACTor device.

15. A method, comprising:
providing a first voltage suppression device having a first voltage suppression device substrate, a first voltage suppression device first base layer, and a first voltage suppression device second base layer, the first voltage suppression device substrate being coupled to the first voltage suppression device first base layer, and being coupled to the first voltage suppression device second base layer;
providing a second voltage suppression device having a second voltage suppression device substrate, a second voltage suppression device first base layer, a second voltage suppression device second base layer, and a second voltage suppression device third base layer, the second voltage suppression device substrate being coupled to the second voltage suppression device first base layer and being coupled to the second voltage suppression device second and third base layers, wherein the second voltage suppression device first base layer includes one or more first regions, the second voltage suppression device includes a doping region disposed across at least portions of the second voltage suppression device first base layer and the second voltage suppression device substrate; and
coupling the first voltage suppression device and the second voltage suppression device.
